# EUROPEAN PATENT APPLICATION

(11) **EP 3 328 170 A1**
(43) Date of publication of application: **30.05.2018**
(21) Application number: 16382562.3
(22) Date of filing: 24.11.2016
(51) Int. Cl.: H05K 3/14

(54) **PROTECTIVE WALLS FOR DIRECTLY DEPOSITED CONDUCTIVE TRACK**

(71) Applicant: VALEO ILUMINACION, 23600 Martos (ES)
(72) Inventor: TEBA, Daniel, 23600 MARTOS (ES); GUZMAN, Alfonso-Manuel, 23560 HUELMA (ES); MARTINEZ, Francisco, 18500 GUADIX (Granada) (ES)

(57) **Abstract**

An electronic assembly which comprises a plastics substrate in turn comprising a protected surface laterally delimited a first wall extending longitudinally along a first edge and a second wall extending longitudinally along a second edge, in such a way that the protected surface is between the first and second walls, the electronic assembly further comprising a conductive track directly deposited between the first and second walls.

## Description

The present invention belongs to the field of electronic assemblies comprising conductive tracks directly deposited on a plastics substrate.

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Furthermore, the process of direct deposition of the conductive track usually implies shorter manufacturing times and conductive material savings - in contrast to most PCB manufacturing methods, there is no need for removing regions of conductive material or for using an additional product, such as an electrolyte, to define the conductive track.

However, conductive tracks obtained by direct deposition are in some occasions fragile, which leads to maintenance problems during manufacturing or packaging of the electronic assembly. A solution to such problems known in the state of the art consists of providing a plastics film over the surface of the substrate on which the conductive tracks are deposited until the moment of the final integration of the electronic assembly into the device. This solution may be time-consuming, since it requires at least an additional manufacturing step to apply and remove the plastics film; besides, the protection is only effective when the plastics film is on the substrate (as a result of which, manipulations after the final integration might also give rise to damages in the conductive tracks) and when the film is in good conditions (that is, a defect in the film may lead to the deterioration of the conductive track too).

The present invention aims at providing an electronic assembly wherein the directly deposited conductive tracks are permanently protected from manipulation, without falling back on an additional manufacturing step or on a further temporary protective element whose good condition need to be monitored.

To achieve so, the electronic assembly comprises:
- a plastics substrate, the plastics comprising a protected surface, the protected surface being laterally delimited by a first edge and by a second edge; the plastics substrate comprising a first wall extending longitudinally along the first edge and a second wall extending longitudinally along the second edge, in such a way that the protected surface is between the first and second walls,
- a conductive track directly deposited on the plastics substrate, in such a way that the conductive track comprises a protected section directly deposited on the protected surface, the protected section being thereby located between the first and second walls.

The plastics substrate comprises a protected surface, which is configured not to be damaged during manipulation. The protected surface is laterally delimited by a first edge and by a second edge. Hence, these edges are the longitudinal ends of the protected surface. In turn, the first and second walls extend respectively along the first and second edges, thereby giving rise to a cavity-like region over the protected surface.

The conductive track is directly deposited on the plastics substrate in such a way that at least part of the conductive track, referred to as the protected section, is directly deposited on the protected surface. Hence, even if the electronic assembly is manipulated close to or directly at the region where the protected section extends, what is contacted is the uppermost part of the first and second walls, the protected surface, and therefore the protected section, remaining separated from the manipulating object by the cavity-like region over them.

"Directly depositing the conductive tracks" is construed as forming the final shape of the conductive track on the plastics substrate without the need for removing metal and for any other intermediate element, such as a mask, an electrolyte or any other chemical bath or a photosensitive film.

The provision of the first and second walls is a simple and economic manner of protecting the conductive tracks; as will be detailed below, they may for instance be obtained in the same moulding step as the rest of the plastics substrate. The first and second walls may also be incorporated into the plastics substrate in a further step, in which case they may be made of plastics or of any other suitable material.

The protected section may be limited to the zones of the conductive track more prone to deterioration. In an embodiment, however, the protected section corresponds to the whole conductive track. This configuration is particularly suitable for very sensitive electronic assemblies, which require maximum protection.

The claimed arrangement can also be advantageously applied to three-dimensional plastics substrates. A "three dimensional plastics substrate" should be construed as a plastics substrate whose surface on which the conductive track extends is not contained in a single plane. Direct deposition is particularly appropriate for such three-dimensional surfaces, in comparison to other known techniques which normally require planar surfaces for printing a circuit board. The first and second walls can be formed on three-dimensional plastics substrates to protect the protected section of the conductive track directly deposited on such non-planar surface.

In an embodiment, the protected surface has a U-shaped cross-section. The cross-section of the protected surface is transverse to the first and second edges. This particular shape has proven to be effective both for avoiding discontinuities in the conductive track which could appear as a result of sharp edges and for giving the required protection from manipulation.

The first wall may comprise a first top planar surface and the second wall may comprise a second top planar surface. Such first and second top planar surfaces are the uppermost parts of the first and second walls, i.e. the parts the farthest from the plastics substrate (or from the rest of the plastics surface if the walls and the plastics surface are the same part). When the region of the electronic assembly comprising the first and second wall is manipulated, the first and second top planar surfaces keep the protected section from being directly contacted while avoiding the presence of sharp corners which could harm a user manipulating the assembly.

The height of the first and second top planar surfaces may be comprised within a range of 1mm and 20mm, which is usually adequate for achieving the goals of the invention (the concrete value within this range being chosen in function of the electric current the conductive track is intended for). The height of a top planar surface at a given point of that planar surface is calculated as follows - a plane containing such point and perpendicular to the first or the second edge, depending on if the point belongs to the first or the second planar surface, is obtained; then, the corresponding height is the distance between an upper intersection line of such plane with the first (or second) top planar surface and a lower intersection line of the first (or second) wall with the plastics surface or with the rest of the plastics surface if the walls and the plastics surface are the same part.

The first and second top planar surfaces may be substantially parallel to the surface of the plastics substrate on which the first and second walls are formed, i.e. parallel to the surface of the plastics surface closest to the lower intersection line.

The minimum distance between the first and second edges may be comprised between 1mm and 10mm, which is normally a suitable range for protecting the protected section from the type of manipulation an electronic assembly is subjected to during the manufacturing of a lighting device.

The conductive track may be directly deposited on the plastics substrate by means of the plasma deposition technique, e.g. employing the device claimed in document US 2015/0174686 A1.

The claimed electronic assembly may be advantageously used as the control board of a lighting device for an automotive vehicle. Such lighting device would thus comprise:
- an electronic assembly according to any of the embodiments described above,
- a light source electronically connected to the electronic assembly,
- an optical element suitable for receiving light emitted by the light source and for shaping the light into a light pattern projected outside the lighting device,
- a housing accommodating the electronic assembly, the light source and the optical element.

An optical element is an element that has some optical properties to receive a light beam and emit it in a certain direction and/or shape. The optical element can be, among others, a reflector for reflecting the light emitted by the light source, a collimator for concentrating the light, a light guide, a projection lens suitable for outwardly projecting the desired light pattern when the lighting device is installed in the automotive vehicle or the combination of these and other optical elements well known by the person skilled in automotive lighting.

A device for providing a signaling function is also considered as a lighting device in the present document.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may, for instance, coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

However, the lighting device's parts are in general manipulated to a great extent during the manufacture and assembly of the final product, which could damage the usually fragile directly-deposited conductive tracks. The solution of the present invention manages to achieve the advantages of direct deposition of conductive tracks in a lighting device while providing a permanent, consistent, easy-to-achieve protection from manipulation for such conductive tracks.

The present invention does also cover a method of manufacturing an electronic assembly according to the above embodiments, the method comprising the steps of:
a.- manufacturing a plastics substrate in such a way that a protected surface is formed on the plastics surface, the protected surface being laterally delimited by a first edge and by a second edge; the plastics substrate forming a first wall extending longitudinally along the first edge and a second wall extending longitudinally along the second edge, the protected surface being thereby between the first and second protective walls,
b.- directly depositing a conductive track on the plastics substrate in such a way that that the conductive track comprises a protected section directly deposited on the protected surface, the protected section being thereby located between the first and second walls.

The advantages specified above for the electronic assembly also apply to this method.

Step **a** may be carried out by plastics moulding, which is beneficial in that the first and second walls are obtained at the same time and forming the same piece as the rest of the plastics substrate. In alternative embodiments, the plastics substrate and the first and second walls may be obtained independently from each other, by moulding or by any other suitable method, and subsequently attached along the first and second edges.

Step **b** may be carried out by means of plasma deposition, e.g. using the device described in US 2015/0174686 A1, and more concretely in its claim 1.

These and other features and advantages of the invention will become more evident from the following detailed description of preferred embodiments, given only by way of illustrative and non-limiting example, in reference to the attached figures:
Figure 1 depicts a perspective view of an electronic assembly comprising a plastics substrate and a conductive track having a protected section protected by a first and a second walls.
Figure 2 represents a closer perspective view of the protected section and of the first and second walls, additionally showing a cross-section of the plastics substrate.
Figure 3 shows a lighting device comprising an electronic assembly according to the invention.

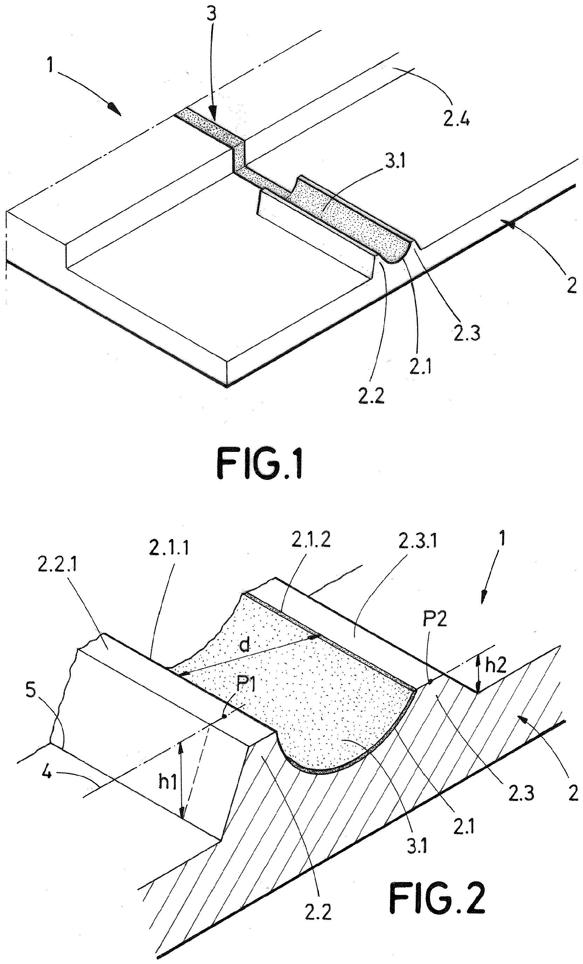

In the embodiment of figure 1, the plastics substrate 2 forms a first wall 2.2 and a second wall 2.3, that is, the first 2.2 and second 2.3 are part of the plastics substrate 2.

A protected surface 2.1 is defined between the first 2.2 and second 2.3 walls. The protected surface 2.1 is thereby protected from manipulation thanks to the first 2.2 and second 2.3 walls. In other embodiments (not represented), the first and second walls are parts different from, and attached to, the plastics substrate 2.

The plastics substrate 2 of the embodiment of figure 1 is three-dimensional, since the surface of the plastics substrate 2 on which a conductive track 3 extends is not contained in a single plane. In the present case, there is a step 2.4 that the conductive track descends. The conductive track 3 has been directly deposited on the plastics substrate 2, which is particularly convenient for laying conductive tracks on such irregular (i.e. non-planar) surfaces.

A protected section 3.1 of the conductive track 3 extends on the protected surface 2.1. In consequence, the protected section 3.1 is likewise protected from manipulation due to the first 2.2 and second 2.3 walls. In other embodiments, the entire conductive track 3 runs over the protected surface 2.1, that is, the protected section 3.1 corresponds to the whole conductive track.

In the more detailed embodiment of figure 2, the uppermost part of the first wall 2.2 is the first top planar surface 2.2.1 and the uppermost part of the second wall 2.3 is the second top planar surface 2.3.1. The first 2.2.1 and second 2.3.1 top planar surfaces have respective first h1 and second h2 heights at first P1 and second P2 points. The first h1 and second h2 heights are calculated as explained above - as the distances between an upper intersection line 4 resulting from the intersection of a plane perpendicular to the first 2.1.1 (or second 2.1.2) edge containing the first P1 (or second P2) point with the first 2.2.1 (or second 2.3.1) top planar surface and a lower intersection line 5 resulting from the intersection of the first 2.2 (or second 2.3) wall with the rest of the plastics surface 2. In this embodiment, the first 2.2.1 and second 2.3.1 top planar surfaces are parallel to the surface of the plastics surface 2 closest to the lower intersection line 5.

The frontiers between the protected surface 2.1 and the first 2.2 and second 2.3 walls are respectively referred to as first edge 2.1.1 and second edge 2.1.2 and; in the embodiment of the figure, they are separated from one another by a distance d.

The protected surface 2.1 of this embodiment has a U-shaped cross-section, as is depicted in figure 2 wherein a cross-section of the plastics substrate 2 is represented.

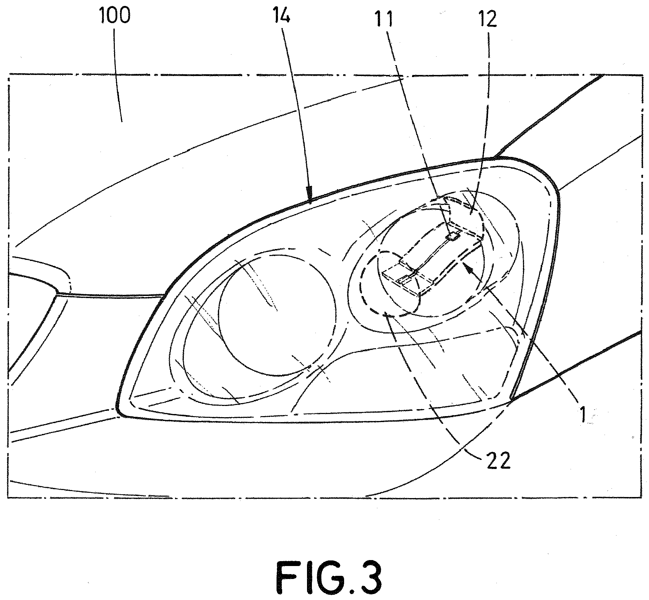

Figure 3 depicts a lighting device 10 for an automotive vehicle 100 comprising a light source 11, a reflector 12 for reflecting light emitted by the light source 11 and a projection lens 22 for projecting a certain light beam pattern. The light source 11 is in turn controlled by an electronic assembly 1, e.g. the electronic assembly of the embodiments of figures 1 and 2. The light source 11, the reflector 12, the projection lens 22 and the electronic assembly 1 are accommodated in a housing 14. In the example of figure 3, the plastics substrate 2 may be a plastics coating over a heat sink (not represented) which plays the role of evacuating the heat generated by the light source 11.

### References

- 1.-: Electronic assembly
- 2.-: Plastics substrate
- 2.1.-: Protected surface
- 2.1.1.-: First edge
- 2.1.2.-: Second edge
- 2.2.-: First wall
- 2.2.1.-: First top planar surface
- 2.3.-: Second wall
- 2.3.1.-: Second top planar surface
- 2.4.-: Step
- 3.-: Conductive track
- 3.1.-: Protected section
- 4.-: Upper intersection line
- 5.-: Lower intersection line
- 10.-: Lighting device
- 11.-: Light source
- 12.-: Optical element
- 14.-: Housing
- 22.-: Projection lens
- 100.-: Automotive vehicle
- h1.-: First height
- h2.-: Second height
- d.-: Minimum distance
- P1.-: First point
- P2.-: Second point

## Claims

1. An electronic assembly (1) comprising:
- a plastics substrate (2), the plastics substrate (2) comprising a protected surface (2.1), the protected surface (2.1) being laterally delimited by a first edge (2.1.1) and by a second edge (2.1.2); the plastics substrate (2) comprising a first wall (2.2) extending longitudinally along the first edge (2.1.1) and a second wall (2.3) extending longitudinally along the second edge (2.3.1), in such a way that the protected surface (2.1) is between the first (2.2) and second (2.3) walls,
- a conductive track (3) directly deposited on the plastics substrate (2), in such a way that the conductive track (3) comprises a protected section (3.1) directly deposited on the protected surface (2.1), the protected section (3.1) being thereby located between the first (2.2) and second (2.3) walls.

2. The electronic assembly (1) of claim 1, wherein the protected section (3.1) corresponds to the whole conductive track (3).

3. The electronic assembly (1) of any one of claims 1 and 2, wherein the plastics substrate (2) is three-dimensional.

4. The electronic assembly (1) of any one of claims from 1 to 3, wherein the protected surface (2.1) has a U-shaped cross-section.

5. The electronic assembly (1) of any one of claims from 1 to 4, wherein the first wall (2.2) comprises a first top planar surface (2.2.1) and the second wall (2.3) comprises a second top planar surface (2.3.1).

6. The electronic assembly (1) of claim 5, wherein a first height (h1) of the first top planar surface (2.2.1) and a second height (h2) of the second top planar surface (2.3.1) are between 1mm and 20mm.

7. The electronic assembly (1) of any one of claims from 1 to 6, wherein a minimum distance (d) between the first edge (2.1.1) and the second edge (2.1.2) is between 1mm and 10mm.

8. The electronic assembly (1) of any one of claims from 1 to 7, wherein the conductive track (3) is directly deposited on the plastics substrate (2) by means of plasma deposition.

9. A lighting device (10) for an automotive vehicle, the device comprising:
- an electronic assembly (1) according to any one of claims from 1 to 8,
- a light source (11) electronically connected to the electronic assembly (1),
- an optical element (12) suitable for receiving light emitted by the light source (11) and for shaping the light into a light pattern projected outside the lighting device,
- a housing (14) accommodating the electronic assembly (1), the light source (11) and the optical element (12)

10. A method of manufacturing an electronic assembly (1) according to any one of the preceding claims, the method comprising the steps of:
a.- manufacturing a plastics substrate (2) in such a way that a protected surface (2.1) is formed on the plastics surface (2), the protected surface (2.1) being laterally limited by a first edge (2.1.1) and by a second edge (2.1.2); the plastics substrate (2) comprising a first wall (2.2) extending longitudinally along the first edge (2.1.2) and a second wall (2.3) extending longitudinally along the second edge (2.1.2), the protected surface (2.1) being thereby between the first (2.2) and second (2.3) walls;
b.- directly depositing a conductive track (3) on the plastics substrate (2) in such a way that that the conductive track (3) comprises a protected section (3.1) directly deposited on the protected surface (2.1), the protected section (3.1) being thereby located between the first (2.2) and second (2.3) walls.

11. The method of claim 10, wherein step **a** is carried out by plastics moulding.

12. The method of claims 10 or 11, wherein step b is carried out by means of plasma deposition.
